# EUROPEAN PATENT APPLICATION

(11) **EP 2 925 102 A1**
(43) Date of publication of application: **30.09.2015**
(21) Application number: 14162438.7
(22) Date of filing: 28.03.2014
(51) Int. Cl.: H05K 5/06, H01F 27/14

(54) **Pressure compensator failure detection**

(71) Applicant: Siemens Aktiengesellschaft, 80333 München (DE)
(72) Inventor: Kristensen, Knut Schonhowd, 7012 Trondheim (NO)

(57) **Abstract**

A method of detecting a failure in a pressure compensation system (100), in which a group of pressure compensators (10,20) compensate volume changes of a liquid in a chamber (112) of a subsea device (110), is provided. The group of pressure compensators includes at least a first pressure compensator (10,20) and one or more further pressure compensators (10,20), each pressure compensator comprising a movable or deformable element such as a bellows (16,26). The pressure compensators in the group are biased by a biasing device (19,29) acting on the respective pressure compensators so that the pressure inside the pressure compensators is larger than a pressure prevailing in a medium surrounding the subsea device. Measuring devices (61,62) on the pressure compensators detect the displacement of the pressure compensators. Based on the detection of drift in a displacement measured for at least one pressure compensator and using valves (13,23) for isolating at least one pressure compensator from the other pressure compensators, it is determined whether the first pressure compensator has failed or whether one of the further pressure compensators has failed, thus determining the location of the failed pressure compensator.

## Description

### Field of the invention

The present invention relates to a method of detecting a failure in a pressure compensation system, and to a pressure compensation system for compensating volume variations of a liquid in a chamber of a subsea device.

### Background

Due to the increasing energy demand, offshore oil and gas production is moving into deeper waters. For ensuring an efficient and secure production of hydrocarbons from a subsea well, processing facilities are being installed at the ocean floor. Such subsea installations can comprise a range of components, including pumps, compressors and the like as well as a power grid for providing such components with electric power. The power grid may for example comprise a subsea transformer, subsea switchgear and subsea variable speed drives (VSDs). Such components of a subsea installation may be installed at water depths of 3,000 m or more, so that they are exposed to pressures up to or even in excess of 300 bars. To protect such components from the corrosive seawater and to handle the high pressures prevailing in such subsea environment, these components are provided with subsea enclosures.

The construction of such subsea enclosures is technically challenging. Two solutions are proposed for dealing with these high pressures. A pressure resistant enclosure can be provided, which has a close to atmospheric internal pressure, enabling the use of conventional electric and electronic components. Such enclosures need to have relatively thick walls and are thus bulky and heavy, since they have to withstand high differential pressures.

Another solution is the use of pressurized (or pressure compensated) enclosures, which comprise a volume/pressure compensator which balances the pressure in the enclosure to the pressure prevailing in the ambient seawater. The pressure compensated enclosure is generally filled with a liquid, and components operated inside the pressure compensated enclosure are made to be operable under high pressures. The pressure/volume compensator compensates variations in the volume of the liquid filling the enclosure, which may occur due to variations in ambient pressure and/or in temperature. Temperature changes can be caused by deployment at the subsea location and by internal heating, e.g. due to electric losses.

Pressure compensators may include metal bellows, rubber bellows, pistons or the like. As an example, the document WO 2010/034880 A1 discloses a pressure compensator which has a first bellows chamber which is surrounded by a second bellows chamber, the second bellows chamber forming a closed intermediate space around the first bellows chamber. A double barrier against the ingress of seawater is thus obtained.

Furthermore, the document WO 2011/088840 A1 discloses a pressure compensation system which achieves a double barrier against the ingress of seawater.

Such type of double barrier may increase the safety and reliability of the pressure compensator only insignificantly. A failure of the pressure compensator is generally caused by fatigue of the material of the bellows part, i.e. by the formation of cracks and thus leaks in the bellows part of the pressure compensator. As an example, through such crevice in the outer bellows portion, seawater may leak into the intermediate chamber, where it is stopped by the inner bellows part. Even so, it must be noted that both bellows parts undergo the same compression/decompression cycles, and are accordingly experiencing the same stress and fatigue. Both bellows portions are thus likely to fail within a relatively short period of time. Accordingly, the lifetime and thus the safety and reliability of such double barrier pressure compensator are not extended significantly by the second barrier.

The document US 2013/0167962 A1 discloses a configuration which makes use of a particular arrangement of two bellows, thus increasing the compensation volume and keeping the dead volume small. A single barrier configuration having an improved reliability can thus be achieved.

Nevertheless, it is desirable to further increase the reliability of a pressure compensator for a subsea device. It is desirable to both improve the protection against ingress of seawater, and furthermore increase the lifetime over which such pressure compensator can be operated.

### Summary

Accordingly, there is a need for providing improved pressure compensation for a subsea device, and in particular to achieve pressure compensation with improved reliability.

This need is met by the features of the independent claims. The dependent claims describe embodiments of the invention.

According to an embodiment of the invention, a method of detecting a failure in a pressure compensation system is provided. A group of pressure compensators, including for example the above outlined first and second pressure compensators, is provided for compensating volume changes of a liquid in a chamber of a subsea device. The group of pressure compensators comprises at least a first pressure compensator and one or more further pressure compensators. The method comprises biasing the pressure compensators in the group such that the pressure inside the pressure compensators is larger than a pressure prevailing in a medium surrounding the subsea device; operating the pressure compensation system in a state or bringing the pressure compensation system into a state in which a flow connection between the first pressure compensator and the one or more further pressure compensators is closed; measuring the displacement of at least one pressure compensator in the group; and determining the location of a failed pressure compensator based on the measured displacement by determining whether the first pressure compensator has failed or whether one of the further pressure compensators has failed based on the detection of drift in the measured displacement.

By making use of such method, it may be detected in a fast and efficient way in a system having plural pressure compensators which pressure compensator has actually failed. By such method, this can be achieved even if only the displacement of a single pressure compensator is measured. This may allow a fast and efficient isolation of the failed pressure compensator. By providing plural pressure compensators in parallel and using such method, the reliability and lifetime of the pressure compensation system may be improved significantly. The fast detection of a failed pressure compensator and the biasing of the pressure compensators may further improve the protection against the ingress of seawater.

Preferably, the displacement of each pressure compensator is measured. As an example, if the displacement of the first pressure compensator is measured and shows drift, it is determined that the first pressure compensator has failed, in particular that it has a leak through which liquid filling the pressure compensator may leak out due to the biasing. By introducing the biasing of the pressure compensator, it is further achieved that drift can be used as a means for detecting pressure compensator failure. If in the example, the displacement of the first pressure compensator does not show drift, it can be determined that one of the further pressure compensators has failed, e.g. that the second pressure compensator has failed if the system comprises two pressure compensators.

In an embodiment, the method may further comprise the step of determining the presence of a failure by detecting drift in displacement of at least one pressure compensator or said group. When plural pressure compensators are active, this may be performed as an additional step before closing the flow connection. When only one pressure compensator is active, this may be performed simultaneously with the determination of the location of the failed pressure compensator, if the first pressure compensator shows drift, it can be determined that a fault occurred and that the location of the fault is the first pressure compensator based on the same displacement measurement.

In an embodiment, after closing the flow connection between the first pressure compensator and the further pressure compensators, when the displacement of the first pressure compensator is measured, it can be determined that the first pressure compensator has failed if the measure displacement shows drift, and it can be determined that one of the further pressure compensators has failed if the measured displacement does not show drift. In the latter case, it is possible to continue the method by taking another pressure compensator of the group as the first pressure compensator and repeating the method. This way, it can be determined efficiently which pressure compensator has failed.

In an embodiment, the displacement of each pressure compensator in the group may be detected. Detection of the location of the failed pressure compensator may thus be accelerated.

A flow connection may be provided between each pressure compensator and the chamber of the subsea device, and a controllable valve may be disposed in each flow connection.

Operating the pressure compensation system in a state or bringing the pressure compensating system into a state in which the flow connection between the first pressure compensator and the one or more further pressure compensators is closed may comprise providing a flow connection between one pressure compensator of the group of pressure compensators and the chamber in an open state to enable flow communication between the pressure compensator and the chamber and providing flow connections between the other pressure compensators of the group and the chamber in a closed state. Thus, it can be ensured that during the failure detection, one pressure compensator always remains active for compensating volume variation of the liquid in the chamber.

After detecting the failed pressure compensator, the method may further comprise the step of closing a flow connection between the failed pressure compensator and the chamber. Ingress of seawater into the chamber may thus be prevented.

The step of determining the location of the failed pressure compensator may be performed by a control unit, in particular by means of a control unit configured as described herein.

The system may be operated or brought into the state in which the flow connection between the first pressure compensator and the one or more further pressure compensators is closed by closing a controllable valve between the first pressure compensator and the chamber, or closing a controllable valve between the one or more further pressure compensators and the chamber.

In some embodiments, the further pressure compensators may comprise at least a second and a third pressure compensator. If it is determined that one of the further pressure compensators has failed, the method may further comprise bringing the pressure compensation into a state in which a flow connection between the second pressure compensator and the third pressure compensator is closed, detecting the displacement of at least the second or the third pressure compensator and, based on the detected displacement, determining whether the second or the third pressure compensator has failed. Accordingly, also with more than two pressure compensators, it can be detected fast and efficiently which pressure compensator has failed. It should be clear that more than three pressure compensators may be provided, and that the method may be applied correspondingly.

According to an embodiment, a pressure compensator system for compensating volume changes of a liquid in a chamber of a subsea device is provided. The pressure compensation system comprises a group of pressure compensators including at least a first pressure compensator and one or more further pressure compensators. Flow connections are provided between pressure compensator and the chamber. Controllable valves are disposed in the flow connections. For each pressure compensator, a biasing device adapted to bias the pressure compensator is provided, the biasing being such that the pressure inside the pressure compensator, in particular in the compensation volume, is larger than a pressure prevailing in a medium surrounding the subsea device. A measuring unit is adapted to measure the displacement of at least one pressure compensator in the group, and a control unit is provided for controlling the valves. The pressure compensation system is configured to perform any of the above outlined methods. The control unit may in particular be adapted to control the operation of the pressure compensation system and to perform the determination of the location of the failed pressure compensator and to detect drift in the measured displacement.

In an embodiment, the pressure compensation system comprises a subsea enclosure of the subsea device which encloses the chamber. It further comprises at least a first pressure compensator which has a first compensation volume and which is adapted to provide a pressure balancing between ambient medium surrounding the subsea device and the first compensation volume, wherein a flow connection is provided between the first compensation volume and the chamber, and a first biasing device configured to bias the first pressure compensator such that pressure in the first compensation volume is higher than the pressure in the ambient medium surrounding the subsea device. In such configuration, a small overpressure compared to the pressure of the ambient medium may be provided in the first compensation volume and thus in the chamber.

In the embodiment, a second pressure compensator is further provided having a second compensation volume and being adapted to provide a pressure balancing between the ambient medium surrounding the subsea device and the second compensation volume. A flow connection is provided between the second compensation volume and the chamber. A second biasing device is configured to bias the second pressure compensator such that the pressure in the second compensation volume is higher than the pressure in the ambient medium surrounding the subsea device. The pressure compensation system further includes a controllable first valve arranged in the flow connection between the first compensation volume and the chamber, the first valve being operable to stop fluid flow between the first compensation volume and the chamber, and a controllable second valve arranged in the flow connection between the second compensation volume and the chamber, the second valve being operable to stop fluid flow between the second compensation volume and the chamber. A control unit is connected to the first and second valves and adapted to automatically shut the first valve or the second valve upon detecting a failure of the first pressure compensator or the second pressure compensator, respectively.

By biasing the pressure compensators, the ingress of seawater into the compensation volume may be prevented, since a liquid filling the compensation volume will leak out. Furthermore, the detection of a failure of a pressure compensator, in particular a crack or crevice formed in the pressure compensator due to cyclic stress, may be facilitated. By means of the control unit and the controllable valves, it becomes possible to isolate a pressure compensator by closing the respective flow connection and to continue operation with a functioning pressure compensator. In particular, the control unit may be configured so as to maintain the first or the second pressure compensator in a standby mode in which the flow connection of the pressure compensator to the chamber is closed. The isolated pressure compensator may thus not experience the cyclic stresses which act on the other pressure compensator in operation. The lifetime of the pressure compensation system can thus be effectively doubled, since each pressure compensator can be operated over its full lifetime. This is in contrast to e.g. double bellows compensators, in which both bellows experience the same cyclic stresses, thus resulting in an increased likelihood of failure of both bellows within a short period of time.

In other configurations, the control unit may be configured to operate the pressure compensation system with the first and second pressure compensators in parallel, thus reducing the utilization of each pressure compensator, which significantly increases the expected lifetime. Further pressure compensators may of course be provided, e.g. a third, a fourth, a firth or even more pressure compensators, which may be operated correspondingly, whereby reliability and lifetime may be further increased. The first and second pressure compensators and the further pressure compensators, if provided, may be considered to form a group of pressure compensators.

The pressure compensators may only be single walled. They can thus be relatively compact, resulting in a relatively compact pressure compensation system. Furthermore, the flow connections of the first and second pressure compensators may be connected to different parts of the subsea enclosure of the subsea device, thus allowing a separation of the chamber into different compartments. The protection against ingress of seawater and the reliability may thus be improved further.

In an embodiment, the chamber of the subsea enclosure of the subsea device may comprise at least a first and a second compartment, wherein the flow connections of the first and second pressure compensators may lead into the first and second compartments, respectively. The compartments may be configured such that a flow connection for the liquid filling the chamber is provided between the compartments, the flow connection being such that the compartments can be isolated from each other, e.g. by closing a valve. A further safeguard against the ingress of seawater into the chamber may thus be achieved; in particular one part of the chamber may be protected from seawater when the other part of the chamber is experiencing seawater ingress.

In an embodiment, the control unit may be adapted to have a mode of operation in which the first valve and the second valve are open so as to provide pressure compensation of the chamber simultaneously by means of the first and second pressure compensators. This may improve the expected lifetime of each pressure compensator since the utilization of each pressure compensator can remain relatively low.

In an embodiment, the control unit may be adapted to have a mode of operation in which the first valve is open and the second valve is closed so as to provide pressure compensation of the chamber by means of the first pressure compensator and to maintain the second pressure compensator in standby. In standby means that the second pressure compensator does not compensate volume variations of the liquid in the chamber. The second pressure compensator will thus not be exposed to cyclic stresses, so that when the first pressure compensator fails, a new pressure compensator is "in reserve" and can become operational. The overall lifetime of the pressure compensation system may thus be increased significantly.

The control unit may be configured to automatically open the second valve upon detecting a failure of the first pressure compensator. Accordingly, by means of the control unit, the first pressure compensator can be automatically isolated and the second pressure compensator can automatically be put into operation.

The first pressure compensator and/or the second pressure compensator may be a bellows-type pressure compensator. The first and/or the second compensator may comprise first and second end walls and a bellows part disposed between the first and the second end walls. In other embodiments, the first pressure compensator and/or the second pressure compensator may be a membrane compensator, a bladder compensator or a piston compensator.

The first and second pressure compensators may be single barrier pressure compensators having a single bellows wall separating the compensation volume from ambient medium, in particular from surrounding seawater when the pressure compensation system is installed subsea.

According to an embodiment, the pressure compensation system further comprises a first measuring unit adapted to measure the displacement of the first pressure compensator and/or a second measuring unit adapted to measure the displacement of the second pressure compensator. As an example, measuring the displacement may include measuring the movement of an end wall of a bellows compensator, measuring the movement/deformation of a membrane of a membrane compensator, measuring the movement of a piston in a piston compensator or measuring the movement/deformation of a bladder of a bladder compensator. The control unit may be adapted to determine the presence of a failure of the first or second pressure compensators on the basis of the displacement measured with at least one of the first or second measuring units. The first and second measuring units may for example comprise an inductive or an optical sensor to measure the displacement of the respective pressure compensator.

The control unit may be adapted to detect drift in the measured displacement and to determine the presence of a failure upon detecting such drift. Drift may for example be detected when the average displacement of the pressure compensator changes continuously in one direction, in particular when the displacement indicates a continuous decrease of the compensation volume. Preferably, the pressure compensation system is configured such that at least the displacement of the pressure compensator that is initially active, i.e. the valve of which is initially opened, is measured (active pressure compensator).

In an embodiment, the control unit may be adapted to determine the location of a failure at the first or the second pressure compensator by detecting a drift in the displacement of the first or the second pressure compensator when the first compensation volume and the second compensation volume are not in fluid communication. This may for example be achieved by closing the first valve, closing the second valve, closing both valves, or closing a flow connection between two compartments of the chamber, if such are provided. If further pressure compensators are provided, the flow connection between these further pressure compensators and the chamber may be closed in order to determine the location of the failure. In a configuration in which each pressure compensator is provided with a measuring unit for measuring displacement, the pressure compensators may be isolated one after the other to detect displacement and drift for identifying the location of the failed pressure compensator.

The flow connection between the first and/or second compensation volume and the chamber may for example be provided by means of a duct or a pipe, and the respective valve may be disposed in such duct or pipe. The flow connection, in particular the duct or pipe, may enter the pressure compensator through an end wall or a side wall.

The pressure compensation system may furthermore comprise a subsea canister disposed adjacent to the subsea enclosure of the subsea device. The control unit may be arranged in the subsea canister. The control unit may be a controller, in particular control circuitry. As an example, a controller card (PCB) may be provided. In another embodiment, the control unit may for example be part of a protective relay, such as a SIPROTEC relay. The subsea canister may for example be a pressure resistant subsea canister, having a predefined internal pressure of e.g. below 5 bar, for example about 1.5 bar, which allows the operation of conventional electric and electronic components therein. The valves of the pressure compensation system can thus be controlled directly at the subsea installation in a reliable way.

The first and the second pressure compensators may each be sized such that each pressure compensator alone is capable of compensating the volume variations of the liquid in the chamber. If further pressure compensators are provided, these may be configured correspondingly.

In particular, the pressure compensation system may further comprise at least one, two, three or more further pressure compensators, respective biasing devices and respective controllable valves. These components may be configured as described above. The reliability and the lifetime of the pressure compensation system may thus be increased further, since e.g. after failure of two pressure compensators, a third pressure compensator may be put from a standby mode into an active mode, thus keeping the subsea device operable.

The first and the second pressure compensators may be biased by a spring force or by a gravitational force. They may be biased by a weight mounted to a movable upper end plate of the respective compensator or by a spring applying a force to a movable end plate of the compensator. A spring force may also be applied by a bellows portion of a compensator when the respective compensation volume is filled with a liquid such that the bellows portion is stretched. The biasing of the first and second pressure compensators may be similar, yet in some configurations, a different biasing may be provided, for example when the first and second pressure compensators are not operated in parallel.

The first and second valves may each be hydraulically operable or electrically operable. In an embodiment, the first and/or the second valve may be a magnetically actuated valve which is configured to open and close in response to an electric control signal. Such control signal may be provided by the control unit.

In a further embodiment, the pressure compensation system may be configured such that the first and second valves are arranged in the respective compensation volume, or are arranged in the chamber of the subsea device. In such configuration, the protection against ingress of seawater can be further improved, since the valves are protected from the corrosive high pressure seawater environment.

A further embodiment of the invention provides a subsea device, such as a subsea transformer, a subsea switchgear or a subsea variable speed drive, which comprises a pressure compensation system in any of the above outlined configurations.

It is to be understood that the features mentioned above and those yet to be explained below can be used not only in the respective combinations indicated, but also in other combinations or in isolation, without leaving the scope of the present invention. In particular, it should be clear that any of the method steps described above may be performed by embodiments of the described pressure compensation system, and the pressure compensation system can be configured and adapted to perform such method steps. Furthermore, embodiments of the method may comprise any steps described with respect to the pressure compensation system, and may make use of the described pressure compensation system in any disclosed embodiment or configuration.

### Brief description of the drawings

The foregoing and other features and advantages of the invention will become further apparent from the following detailed description read in conjunction with the accompanying drawings. In the drawings, like reference numerals refer to like elements.
Figure 1 is a schematic drawing showing a pressure compensation system according to an embodiment of the invention.
Figure 2 is a schematic drawing showing a pressure compensation system according to a further embodiment of the invention.
Figure 3 is a flow diagram illustrating a method according to an embodiment of the invention.
Figure 4 is a flow diagram illustrating a method according to an embodiment of the invention.
Figure 5 is a flow diagram illustrating a method according to a further embodiment of the invention.

### Detailed description

In the following, the embodiments illustrated in the accompanying drawings are described in more detail. It should be clear that the following description is only illustrative and non-restrictive. The drawings are only schematic representations, and elements in the drawings are not necessarily to scale with each other.

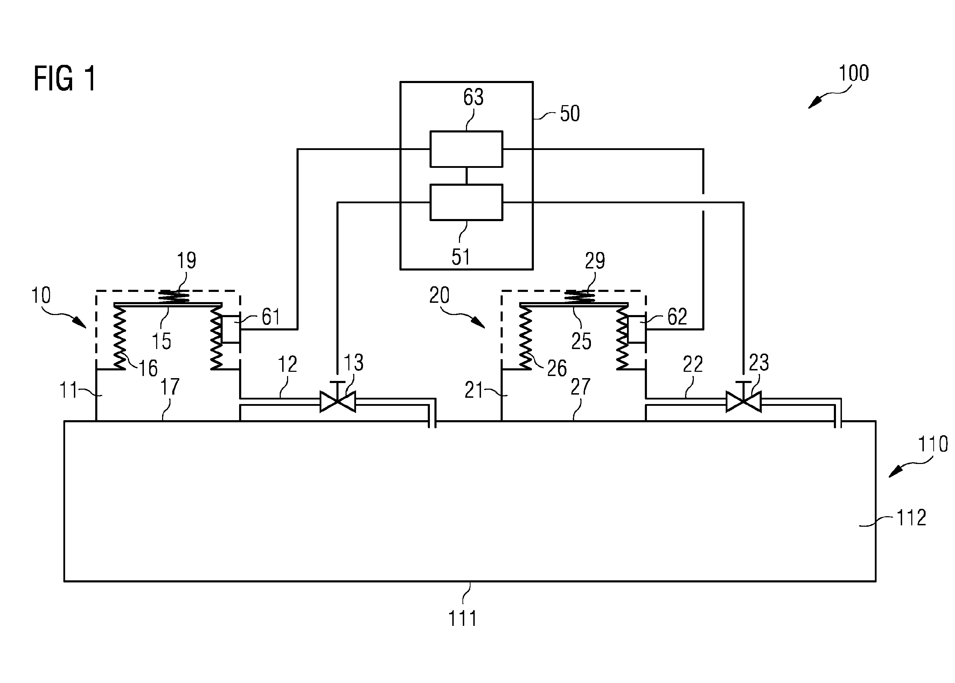

Figure 1 shows a subsea device 110 having a subsea enclosure 111 which forms a chamber 112. The chamber 112 is filled with a liquid, in particular a dielectric liquid, such as transformer oil, silicon oil or the like. A pressure compensation system 100 is provided for compensating volume variations of the liquid filling chamber 112. As an example, the temperature of the liquid can change when the subsea device 110 is installed at the subsea location, it may for example change from about 20°C to about 4°C, which can lead to a significant volume change. Furthermore, in operation, electric or electronic components disposed in the subsea enclosure 111 may generate heat, which may again change the temperature of the liquid and thus its volume. Also, subsea device 110 can be installed in water depths up to or even in excess of 3,000 m, and by means of the volume compensation system 100, the pressure outside the subsea enclosure 111 is transmitted into the chamber 112. When exposed to the high pressures prevailing at such water depths, the volume of the liquid filling chamber 112 may also experience a change due to the compression of the liquid.

Pressure compensation system 100 comprises a first pressure compensator 10, a second pressure compensator 20 and may comprise further pressure compensators. These pressure compensators may be considered to form a group of pressure compensators. Each pressure compensator comprises a movable or deformable element, such as a bellows, membrane, bladder, piston or the like, which allows a pressure equalization between the pressure in the subsea environment surrounding the subsea device 110 when installed subsea, and which further allows the volume of the liquid filling chamber 112 to change without the build-up of excessive overpressure or negative pressure inside the subsea enclosure 111 (compared to the ambient pressure). The pressure compensators are configured such that movement/deformation of this element results in a change of a compensation volume. Any pressure imbalance between internal and ambient pressure will thus result in a force being applied to the movable or deformable element, which will accordingly move/deform so as to balance the pressures.

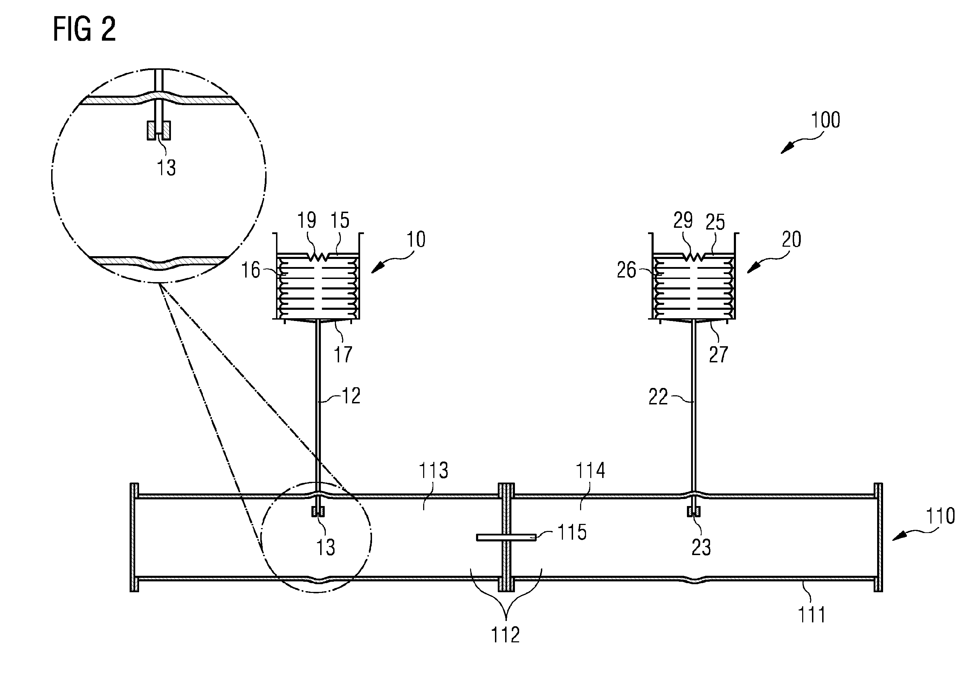

In the example of figure 1, each pressure compensator comprises a movable first end wall in form of the top plates 15, 25 and a bellows part or portion 16, 26. Since the top plates 15, 25 are movable in the axial direction of the bellows parts, the pressure in the surroundings will be transmitted into the respective compensation volume 11, 21. The compensation volume 11, 21 is again filled with a liquid, in particular dielectric liquid. In the example of figure 1, each compensation volume 11, 21 is illustrated with a relatively large dead volume (not available for compensation purposes). This is only for the purpose of a clear and comprehensive presentation to allow a detailed illustration of the flow connections 12, 22, but the dead volume may be minimized in an actual implementation, as for example illustrated in figure 2.

Each compensation volume 11, 21 is connected via a flow connection 12, 22 with the chamber 112. The flow connections 12, 22 can be provided by means of ducts or pipes, yet they may in other configurations also be provided in form of an opening between the respective compensation volume 11, 21 and the chamber 112.

In each flow connection 12, 22, a controllable valve 13, 23 is provided. The valves 13, 23 can be hydraulically or electrically operated to open and close the respective flow connection 12, 22. When the valve 12, 22 is open, the liquid can thus flow between the respective compensation volume 11, 21 and the chamber 112. Accordingly, the compensation volumes 11, 21 and the chamber 112 may be filled with the same liquid. Note that although figure 1 illustrates valves 13 and 23 to be located outside any further enclosure, the valves may be arranged within the respective compensation volume 11, 21, or may preferably be arranged within the chamber 112. Protection of the valves from the subsea environment can thus be achieved.

Each pressure compensator comprises a biasing device 19, 29. The biasing device acts on the respective compensator such that the pressure within the respective compensation volume 11, 21 is slightly increased with respect to the pressure prevailing in the surrounding medium, i.e. with respect to the pressure of the seawater at the subsea installation. The biasing devices 19, 29 apply a force to the movable/deformable element of the respective compensator in a direction such that the pressure inside the respective compensation volume and thus in the chamber 112 is slightly increased. In the example of figure 1, each biasing device 19, 29 may comprise a spring which applies a spring force to e.g. the end wall or top plate 15, 25 of the respective pressure compensator 10, 20. The overpressure created in the respective compensation volumes 11, 21 is proportional to the applied spring force. Such biasing has the effect that if a leak occurs in the system, for example in one of the pressure compensators or in the subsea enclosure 111, the liquid filling the respective volume will leak out and thus prevent any seawater from entering the volume.

In such situation, the pressure compensators will compensate for such loss of liquid. If both pressure compensators are in fluid communication, via their respective flow connections 12, 22 and the chamber 112, such leak will lead to a continuous compression of both bellows portions 16, 26. In other words, the top plate 15, 25 of each pressure compensator starts moving down due to the applied spring force and the loss of liquid.

To detect the position and/or movement of the pressure compensators 10, 20, measuring devices 61, 62 are provided at each pressure compensator. The measuring devices 61, 62 may for example detect the position of the top plate 15, 25. For this purpose, the measuring devices 61, 62 may comprise an optical sensor, an inductive sensor or the like. The measuring devices 61, 62 may for example be configured as described in the documents EP 2,698,610 A1 or EP 2,698,611 A1, the contents of which is herein incorporated by reference in its entirety.

Subsea pressure compensation system 100 further includes a control unit 51. Control unit 51 may be provided in form of a controller, in particular control circuits, it may for example comprise a controller card including a micro processor. Control unit 51 is adapted to control the operation of the valves 13, 23. For electrically operable valves, this may occur via electric control signals, while for hydraulically operated valves, corresponding hydraulic valves are operated by control unit 51 for opening and closing the valves 13, 23.

Pressure compensation system 100 further comprises a subsea canister 50 in which the control unit 51 is disposed. In the example of figure 1, the subsea canister 50 is separate and adjacent to the subsea enclosure 111. In other embodiments, the subsea canister 50 may be mounted to or may be part of the subsea enclosure 111. Subsea canister 50 is preferably a pressure resistant canister, so that a predetermined internal pressure is maintained inside the subsea canister 50 even when installed at the subsea location. Accordingly, conventional electric and electronic components can be used inside the subsea canister 50. It may be maintained at an internal pressure smaller than 5 bar, e.g. at about atmospheric pressure or at about 1.5 bar. In other embodiments, canister 50 may be pressure compensated.

Furthermore, a data acquisition unit 63 is provided in the subsea canister 50. Data acquisition unit 63 is connected to the respective first and second measuring units 61, 62 and acquires data measured by these units. Data acquisition unit 63 may for example comprise a light source required for an optical measurement, it may comprise analogue to digital converters or the like. Control unit 51 and data acquisition unit 63 may be provided on the same or on different circuit boards. By means of data acquisition unit 63, control unit 51 obtains measurements of displacement of the pressure compensators 10, 20, it may for example receive information on the position of the respective top plate 15, 25. Control unit 51 is thus configured to receive and to process information on the state of the pressure compensators, in particular whether they are compressed or extended.

The pressure compensation system 100 can be operated in different modes. In one mode, during normal operation, i.e. when the pressure compensation system 100 is installed subsea and operating to compensate volume variations of the liquid within the chamber 112, one of the valves 13, 23 is open, while the other valve is closed. Accordingly, one pressure compensator is active and compensates the volume variations of the liquid, while the other pressure compensator is in standby and does not contribute to the volume compensation for chamber 112. If the active pressure compensator, say compensator 10, fails e.g. due a crack in the bellows portion 16, liquid will leak out. Top plate 15 will thus move downwards to compress the pressure compensator and accommodate for the lost volume of liquid. This compression is detected by measuring unit 61, e.g. by detecting the movement of the top plate 15. The displacement of the top plate 15 is evaluated by the control unit 51. In such situation, control unit 51 detects a drift in the displacement and will determine that the pressure compensator 10, which is active, has failed. Control unit 51 is configured to close the valve 13 and open the valve 23, so that operation can resume with the second compensator 20 now being active while the first and failed pressure compensator 10 is isolated (flow connection 12 is closed).

Control unit 51 may have further modes of operation. In a further mode of operation, all valves 13, 23 may be opened during normal operation. Control unit 51 may then detect a failure in one of the pressure compensators 10, 20 by detecting a drift in the displacement of both pressure compensators. It may then close one of the valves 13, 23 in order to determine the location of the failed pressure compensator, i.e. to determine which of the two pressure compensators has failed. It will again measure the displacement of both pressure compensators and analyze the measured displacement for drift. The pressure compensator for which drift is detected will then be isolated by control unit 51 (by closing the respective valve 13, 23) and operation continues with the remaining and functioning pressure compensator active.

Note that the pressure compensation system 100 can comprise further pressure compensators to increase the reliability and extend the lifetime of the pressure compensation system. Furthermore, the pressure compensation system 100 may in other embodiments only comprise fewer measuring units. It may even be operated with only a single measuring unit for all pressure compensators. As an example, if compensators 10, 20 are not in flow communication and if the displacement of the second pressure compensator, which is measured, does not show any drift, control unit 51 can derive that the failure is at the first pressure compensator.

Figure 2 shows a further embodiment of the pressure compensation system 100. Since figure 2 is a modification of the system illustrated in figure 1, the explanations given above are equally applicable to the embodiment of figure 2. In figure 2, the measuring units and the control unit are not illustrated for the purpose of a clear presentation, yet they may certainly be present.

In the example of figure 2, the chamber 112 comprises two compartments 113, 114, which are in flow communication during normal operation. Furthermore, a valve 115 is provided between the compartments, by means of which the flow connection between the compartments can be interrupted. The chamber 112 may thus be separated into two fluidically isolated compartments by closing valve 115. The flow connections 12, 22 each lead into a different compartment 113, 114. Accordingly, the flow communication between the pressure compensators 10, 20 can be interrupted by closing the valve 115.

In the embodiment of figure 2, the valves 13, 23 are located inside the compartments 113, 114, and thus within the chamber 112. They can thus be protected from the outside environment.

The first and second biasing devices 19, 29 are in the embodiment of figure 2 provided in form of the end walls or top plates 15, 25 of the respective pressure compensators 10, 20.

By adjusting the weight of the top plates 15, 25, gravitational force will act to compress the respective bellows part 16, 26 and thus create the biasing and the desired overpressure in the medium filling the respective compensation volume. Accordingly, if one of the pressure compensators leaks, the loss of fluid and the gravitational force on the top plates 15, 25 will lead to the top plates moving downwards and compressing the bellows portion 16, 26. Again, such displacement of the pressure compensator can be measured by respective measuring units.

In the example of figure 2, each pressure compensator furthermore has a further end wall 17, 27. The flow connection 12, 22 is provided through this second end wall 17, 27. In such configuration, the dead volume of the respective pressure compensator can be kept low. In other embodiments, the second end wall 17, 27 may abut a wall of the subsea enclosure 111, or may form part thereof, as illustrated in figure 1.

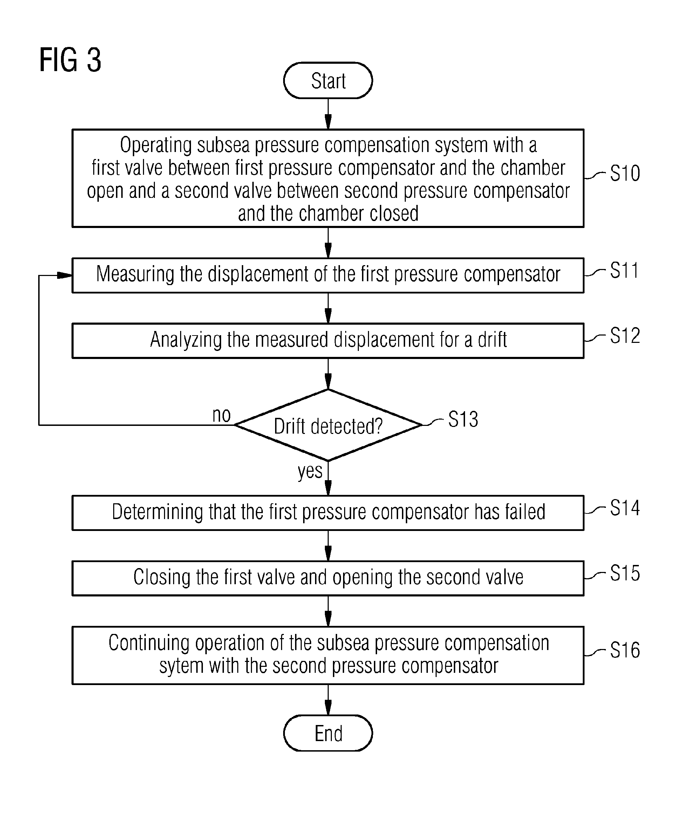

Figure 3 shows a flow diagram of a method according to an embodiment of the invention. The method illustrated in figures 3, 4 and 5 may be performed by the pressure compensation system 100 in any of the configurations described herein.

In step S10, the subsea pressure compensation system 100 is operated with the first valve 13 between the first pressure compensator 10 and the chamber 112 open and a second valve 23 between the second pressure compensator 20 and the chamber 112 closed. In step 11, the displacement of the first pressure compensator 10 is measured, e.g. by measuring unit 61. In step S12, the measured displacement is analyzed for a drift, e.g. by control unit 51. If in decision step S13, no drift is detected in the measured displacement, the method continues with step S11, i.e. the active pressure compensator 10 is continuously being monitored.

If in step S13, drift is detected in the measured displacement, it is in step S14 determined that the first pressure compensator has failed. This determination can be performed by control unit 51. In step S15, control unit 51 closes the first valve 13 and opens the second valve 23. Preferably, at least one of the valves 13, 23 is kept open at any time so as to prevent the build-up of excessive negative or overpressure inside the chamber 112. After step S15, the first pressure compensator 10 is isolated from the system, while the second pressure compensator 20 becomes active. Operation of the subsea pressure compensation system is continued in step S16.

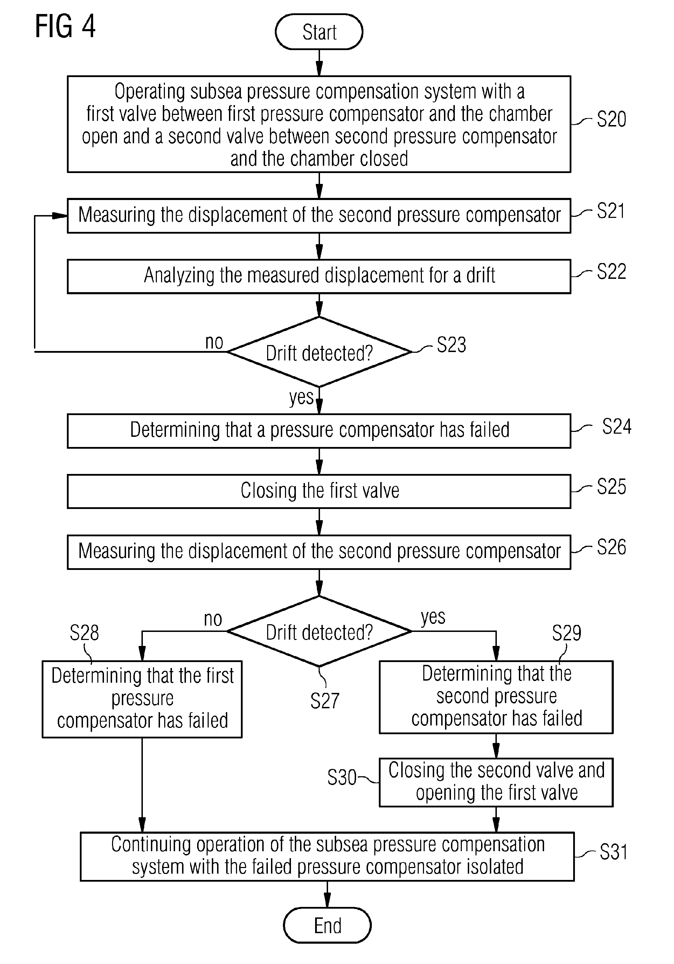

In the example illustrated in the flow diagram of figure 4, the pressure compensation system 100 is operable initially with both valves 13, 23 open. In step S21, the displacement of the second pressure compensator is measured. Note that this may occur alternatively to the measurement of the displacement of the first pressure compensator, or the displacement of both pressure compensators may be measured. In step S22, the measured displacement is analyzed for a drift, which may again be performed by control unit 51. If in step S23, no drift is detected, the method continues with step S21, i.e. the second pressure compensator is continuously being monitored. If in step S23, a drift is detected, it is determined by control unit 51 in step S24 that one of the pressure compensators has failed. Control unit 51 closes the first valve in step S25, thus closing the flow connection between the first and second pressure compensators. The displacement of the second pressure compensator 20 is measured in step S26, e.g. by measuring unit 62. If no drift is detected in decision step S27, control unit 51 can determine that the first pressure compensator has failed (step S28). Accordingly, since the first valve is already closed and the second valve 23 is opened, operation of the subsea pressure compensation system can continue in step S31, with the first pressure compensator being isolated.

If drift is detected in decision step S27, control unit 51 determines in step S29 that the second pressure compensator has failed. It further opens the first valve 13 and closes the second valve 23 in step S30. Operation is then continued in step S31, with the second pressure compensator 20 now being isolated, and first pressure compensator 10 being active.

As can be seen, a fast an efficient method of detecting the location of the failed pressure compensator is provided, and even if such failure occurs, operation can continue.

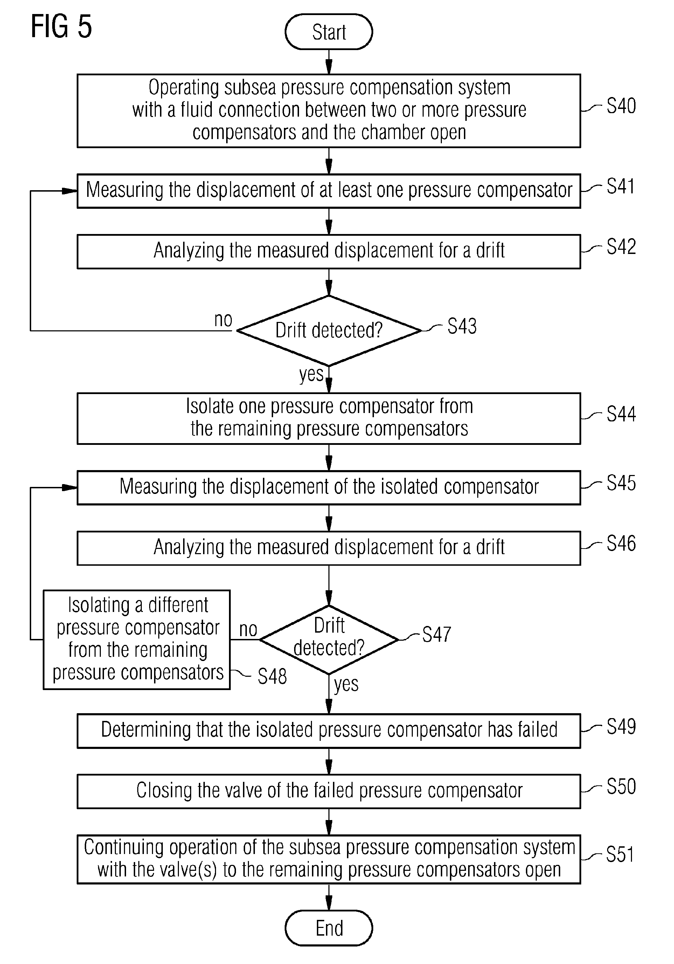

Figure 5 is a flow diagram which illustrates a method that can be performed by a pressure compensation system that has two or more pressure compensators, e.g. three, four, five or more pressure compensators. In step S40, the pressure compensation system 100 is operated with the fluid connection, in particular the valves, between the two or more pressure compensators and the chamber 112 open. As an example, all available pressure compensators may be active and thus in flow communication with chamber 112. The displacement of at least one pressure compensator is measured in step S41. This is sufficient since if one compensator fails, all compensators will show drift. In step S42, the measured displacement is analyzed for drift. If no drift is detected in decision step S43, measuring the displacement and thus monitoring of the at least one pressure compensator is continued in step S41.

If drift is detected in step S43, it is determined that a pressure compensator has failed (step not shown in figure 5). In step S44, one pressure compensator is isolated from the remaining pressure compensators, e.g. by closing the valve in the flow connection of the respective pressure compensator. In the illustrated method, it is assumed that each pressure compensator is provided with a measuring unit 61, 62. In step S45, the displacement of the isolated compensator is measured and analyzed for a drift (step S46). If no drift is detected (decision step S47), a different pressure compensator of the remaining pressure compensators is isolated in step S48, and the method continues with step S45, thus measuring the displacement of the now isolated pressure compensator. This way, all pressure compensators are checked until the pressure compensator which is responsible for the drift is identified.

If drift is detected in decision step S47, it is determined in step S49 that the now isolated pressure compensator has failed. If this is not already the case, then the valve of the failed pressure compensator is closed in step S50. Operation of the subsea pressure compensation system 100 can then continue in step S51 with the valves to the remaining pressure compensators being open. Even in a system comprising multiple pressure compensators, the method thus allows a fast and efficient detection of the location of a failed pressure compensator and the isolation thereof.

In a pressure compensation system having only one displacement sensor, the method may for example be modified by first checking the displacement of the pressure compensator equipment with the measuring unit, and if this pressure compensator is functional, connecting a fluid connection between these pressure compensators and the other pressure compensators, one after the other, so that the pressure compensator which is responsible for the drift can be identified. In another embodiment, one pressure compensator after the other may be disconnected from chamber 112, and the location of the failed compensators may be determined by detecting in which configuration the displacement stops showing drift. The then isolated compensator will be the one that has failed.

Note that the detection schemes described with respect to figures 3-5 can be modified and combined with each other. Furthermore, the pressure compensation system 100 can be configured to perform any of the described methods.

While specific embodiments are disclosed herein, various changes and modifications can be made without departing from the scope of the invention. The present embodiments are to be considered in all respects as illustrative and non-restrictive, and all changes coming within the meaning and equivalency range of the appended claims are intended to be embraced therein.

## Claims

1. A method of detecting a failure in a pressure compensation system (100), in which a group of pressure compensators is provided for compensating volume changes of a liquid in a chamber (112) of a subsea device (110), the group of pressure compensators comprising at least a first pressure compensator (10) and one or more further pressure compensators (20), wherein method comprises:
- biasing the pressure compensators (10, 20) in said group such that the pressure inside the pressure compensators is larger than a pressure prevailing in a medium surrounding the subsea device (110) when installed subsea,
- operating the pressure compensation system (100) in a state or bringing the pressure compensation system (100) into a state in which a flow connection (12, 22) between the first pressure compensator (10) and the one or more further pressure compensators (20) is closed,
- measuring the displacement of at least one pressure compensator (10, 20) in said group,
- determining the location of a failed pressure compensator (10, 20) by determining whether the first pressure compensator (10) has failed or whether one of said further pressure compensators (20) has failed based on a detection of drift in the measured displacement.

2. The method according to claim 1, further comprising the step of:
- determining the presence of a failure by detecting drift in the displacement of at least one pressure compensator (10, 20) of said group.

3. The method according to claim 2, wherein if the pressure compensation system (100) is operated in a state in which the first pressure compensator (10) and one or more further pressure compensators (20) are in fluid communication, the method comprises first determining the presence of a failure by detecting drift in the displacement of one of said pressure compensators (10, 20) and in response thereto bringing the system into the state in which the flow connection (12, 22) between the first pressure compensator (10) and the one or more further pressure compensators (20) is closed.

4. The method according to any of the preceding claims, wherein the pressure compensation system (100) is operated in a state in which at least the first pressure compensator (10) is in flow communication with the chamber (112) via a flow connection (12) and wherein at least the displacement of the first pressure compensator (10) is measured.

5. The method according to any of the preceding claims, wherein after closing the flow connection (12, 22) and when displacement of the first pressure compensator (10) is measured, it is determined that the first pressure compensator has failed if the measured displacement shows drift and it is determined that one of the further pressure compensators has failed if the measured displacement does not show drift.

6. The method according to any of the preceding claims, wherein the displacement of each pressure compensator (10, 20) in said group is detected.

7. The method according to any of the preceding claims, wherein a flow connection (12, 22) is provided between each pressure compensator (10, 20) and the chamber (112) of the subsea device, wherein each flow connection (12, 22) comprises a controllable valve (13, 23).

8. The method according to any of the preceding claims, wherein operating the pressure compensation system (100) in a state or bringing the pressure compensation system (100) into a state in which a flow connection (12, 22) between the first pressure compensator (10) and the one or more further pressure compensators (20) is closed comprises:
- providing a flow connection (12) between one pressure compensator (10) of said group of pressure compensators and the chamber (112) in a open state to enable flow communication between said pressure compensator (10) and said chamber (112),
- providing flow connections (22) between the other pressure compensators (20) of said group of pressure compensators and the chamber (112) in a closed state.

9. The method according to any of the preceding claims, further comprising the step of closing a flow connection (12, 22) between the failed pressure compensator and the chamber (112).

10. The method according to any of the preceding claims, wherein closing the flow connection comprises closing an electrically or hydraulically operated valve (13, 23).

11. The method according to any of the preceding claims, wherein the pressure compensation system comprises a control unit (51), wherein the step of determining the location of the failed pressure compensator is performed by said control unit (51).

12. The method according to any of the preceding claims, wherein operating the pressure compensation system (100) in a state or bringing the pressure compensation system (100) into a state in which the flow connection (12, 22) between the first pressure compensator (10) and the one or more further pressure compensators (20) is closed comprises closing a controllable valve (13) between said first pressure compensator (10) and the chamber (112) or closing a controllable valve (23) between the one or more further pressure compensators (20) and the chamber (112).

13. The method according to any of the preceding claims, wherein the further pressure compensators comprise at least a second (20) and a third pressure compensator, wherein if it is determined that one of the further pressure compensators has failed, the method further comprises:
- bringing the pressure compensation system into a state in which a flow connection between the second pressure compensator (20) and the third pressure compensator is closed,
- detecting the displacement of at least the second or the third pressure compensator, and
- based on the detected displacement, determining whether the second or the third pressure compensator has failed.

14. A pressure compensation system for compensating volume changes of a liquid in a chamber (112) of a subsea device (100), comprising
- a group of pressure compensators, the group of pressure compensators comprising at least a first pressure compensator (10) and one or more further pressure compensators (20),
- flow connections (12, 22) between each pressure compensator (10, 20) of the group of pressure compensators and the chamber (112),
- controllable valves (13, 23) disposed in said flow connections (12, 22),
- biasing devices (19, 29) adapted to bias the pressure compensators (10, 20) in said group such that the pressure inside the pressure compensators is larger than a pressure prevailing in a medium surrounding the subsea device (110),
- a measuring unit (61, 62) adapted to measure the displacement of at least one pressure compensator (10, 20) in said group, and
- a control unit (51) for controlling said valves,
wherein the pressure compensation system (100) is configured to perform the method according to any of claims 1-13.
